# EUROPÄISCHE PATENTANMELDUNG

(11) **EP 0 955 691 A2**
(43) Veröffentlichungstag der Anmeldung: **10.11.1999**
(21) Anmeldenummer: 99102331.8
(22) Anmeldetag: 06.02.1999
(51) Int. Cl.: H01R 9/07, H01R 23/66, H01R 13/70

(54) **Kontaktierungsvorrichtung**

(30) Priorität: 07.05.1998 DE 19820414
(71) Anmelder: Diessner, Carmen, 71065 Sindelfingen (DE)
(72) Erfinder: Diessner, Carmen, 71065 Sindelfingen (DE)
(74) Vertreter: Vetter, Hans, Dipl.-Phys. Dr.

(57) **Zusammenfassung**

Es handelt sich um eine Kontaktierungsvorrichtung (10) für vier von verschiedenen Kontaktseiten (13, 14) her elektrisch zu kontaktierende Drucksensoren (19). Hierfür sind auf einer Bestückungsseite (22) einer flexiblen Leiterplatte (11) zueinander beabstandete Kontaktflächen (24, 25) vorgesehen, die durch Umlegen der Leiterplatte (11) in einem Biegebereich (52) zwischen zwei Kontaktflächen (24, 25) mit an den Drucksensoren (19) vorgesehenen Kontaktgegenflächen (48, 49) zur schnell herstellbaren und sicheren Kontaktierung in Kontakt gelangen.

## Beschreibung

Die Erfindung betrifft eine Kontaktierungsvorrichtung für vier von verschiedenen Kontaktseiten her elektrisch zu kontaktierende Drucksensoren als Bestandteil eines druckempfindlichen Bildschirms.

Es sind Kontaktierungsvorrichtungen bekannt, beispielsweise zum Kontaktieren eines piezoelektrischen Drucksensors, wobei der Drucksensor von der einen Kontaktseite her an einer Kontaktfläche einer Leiterplatte angelötet oder auf andere bekannte Art und Weise elektrisch mit der Kontaktfläche verbunden wird. Bei dem Drucksensor ist es notwendig, ihn des weiteren von der der Leiterplatte entgegengesetzten Kontaktseite her zu kontaktieren. Dies erfolgt über einen kurzen Leiter, beispielsweise Goldfolie, der einerseits am Drucksensor und andererseits an einer zugeordneten Leiterbahn der Leiterplatte angelötet wird. Unter Umständen ist es des weiteren notwendig, zur Abschirmung der Kontaktierung im Bereich des Drucksensors zunächst eine Isolationsschicht und darüber die elektrisch leitfähige Abschirmung anzubringen.

Das Herstellen der elektrischen Verbindung der Kontaktierungsvorrichtung mit dem Drucksensor ist umständlich, aufwendig und daher zeit- und kostenintensiv.

Es ist daher die Aufgabe der vorliegenden Erfindung, eine Kontaktierungsvorrichtung der eingangs genannten Art zu schaffen, die eine sichere und rasch herzustellende Kontaktierung mit den Drucksensoren ermöglicht.

Diese Aufgabe wird durch die Merkmale des Anspruchs 1 gelöst.

Die Kontaktierung der Drucksensoren kann demnach durch einfaches Umlegen der Leiterplatte in ihrem Biegebereich erfolgen, wodurch die beiderseits des Biegebereiches vorhandenen Kontaktflächen mit den zugeordneten Kontaktgegenflächen der Drucksensoren zur Anlage gelangen und eine elektrische Verbindung bewirken. Eine Kontaktierung der Drucksensoren kann hierdurch schnell und sicher erreicht werden.

Vorteilhafte Weiterbildungen des Gegenstands der Erfindung gehen aus den Unteransprüchen hervor.

Zweckmäßigerweise liegen sich im kontaktierten Zustand wenigstens zwei der Kontaktflächen jeweils durch die Drucksensoren voneinander beabstandet gegenüber. Hierdurch wird ein auf entgegengesetzten Kontaktseiten mit Kontaktflächen versehene Drucksensoren elektrisch mit den zugeordneten Kontaktflächen der Leiterplatte einfach und sicher verbunden.

Vorteilhafterweise sind den vier Drucksensoren zugeordnete Kontaktflächen an umlegbaren, laschenähnlichen Partien der Leiterplatte vorgesehen, wobei der Biegebereich jeweils an der laschenähnlichen Partie verläuft. Eine solche laschenähnliche Partie weist eine hohe Biegebeweglichkeit auf, so daß die dort vorgesehene Kontaktfläche sehr leicht zur betreffenden Kontaktgegenfläche der Drucksensoren hin umgelegt oder umgeklappt werden kann.

Bei einer weiteren zweckmäßigen Ausgestaltung sind überwiegend auf der Bestückungsseite der Leiterplatte Signalleiterbahnen vorhanden, die zumindest teilweise mit den Kontaktflächen verbunden sind. Eine derartig ausgeführte Leiterplatte weist einen einfacheren Aufbau auf.

Auf der der Bestückungsseite entgegengesetzten Rückseite der Leiterplatte kann eine elektrisch leitfähige Flächen aufweisende Abschirmung vorgesehen sein, die insbesondere die auf der Bestückungsseite vorhandenen Signalleiterbahnen überdeckt. Hierdurch sind die Signalleiterbahnen von der Rückseite der Leiterplatte her elektrisch abgeschirmt. Wird nun eine Partie der Leiterplatte derart umgeklappt, daß sie sich im wesentlichen parallel zu einer anderen Partie der Leiterplatte erstreckt, so sind die im Bereich der sich gegenüberliegenden Partien verlaufenden Signalleiterbahnen automatisch von beiden Seiten her abgeschirmt, da die beiden Partien der Leiterplatte mit ihren Bestückungsseiten einander zugewandt sind und die abgeschirmten rückseitigen Flächenabschnitte dieser beiden Partien jeweils nach außen weisen. Die von entgegengesetzten Kontaktseiten her zu kontaktierenden Drucksensoren sind daher in kontaktiertem Zustand automatisch von beiden Kontaktseiten her abgeschirmt.

Zur Abschirmung der Signalleiterbahnen von der Bestückungsseite der Leiterplatte her kann diese mittels eines leitfähigen Lacks oder eines leitfähigen Rahmens abgedeckt sein. Der leitfähige Rahmen ist hierbei Bestandteil eines druckempfindlichen Bildschirms (touch panel), wobei die Kontaktierungsvorrichtung ebenfalls einen Bestandteil dieses Gerätes darstellt.

Eine einfache Anbringung der Drucksensoren an der Leiterplatte kann dadurch erfolgen, daß zur elektrischen und mechanischen Verbindung der Kontaktflächen der Leiterplatte mit den jeweils zugeordneten Kontaktgegenflächen der Drucksensoren Klebeschichten vorgesehen sind. Hierbei sind die Klebeschichten vorzugsweise von jeweils einer beidseitig mit Leitkleber versehenen Leitfolie gebildet, die bei hergestellter Verbindung jeweils zwischen Kontaktfläche und zugeordneter Kontaktgegenfläche angeordnet ist. Bei dieser Ausgestaltung kann die Kontaktierung der Drucksensoren besonders einfach und schnell durchgeführt werden.

Im folgenden wird anhand der beigefügten Zeichnung ein Ausführungsbeispiel der erfindungsgemäßen Kontaktierungsvorrichtung näher erläutert. Es zeigen:
- Fig. 1: ein Ausführungsbeispiel einer Kontaktierungsvorrichtung mit U-artig gestalteter Leiterplatte in einer Draufsicht auf die Bestückungsseite der Leiterplatte bei nicht hergestellter Kontaktierung,
- Fig. 2: das Ausführungsbeispiel der Kontaktierungsvorrichtung aus Fig. 1 in Gebrauchslage als Bestandteil eines druckempfindlichen Bildschirms in einer schematischen Darstellung,
- Fig. 3: einen Eckbereich der Kontaktierungsvorrichtung aus Fig. 1 bei hergestellter Kontaktierung mit einem nicht erkennbaren Drucksensor im Schrägbild,
- Fig. 4: den Eckbereich der Kontaktierungsvorrichtung aus Fig. 3 in einer Seitenansicht gemäß Pfeil IV in Fig. 3,

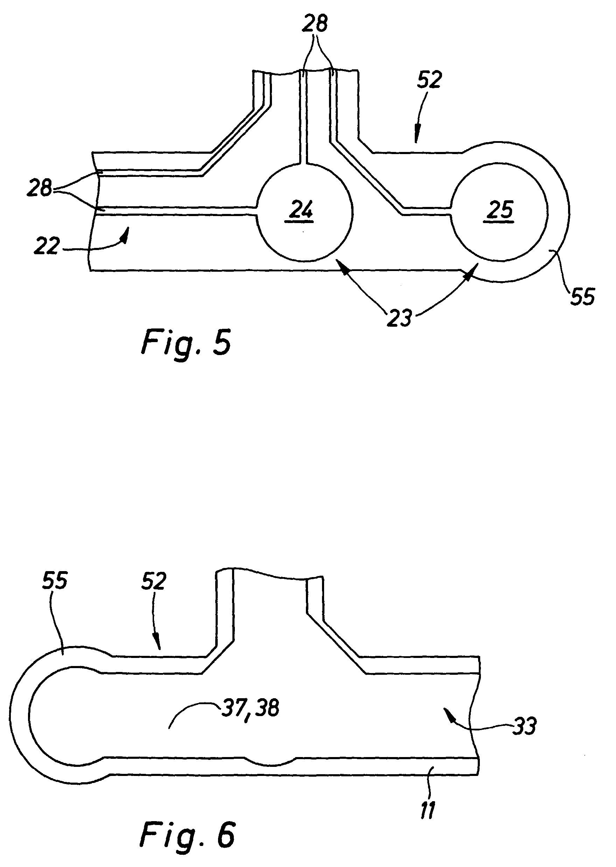

- Fig. 5: den Eckbereich der Kontaktierungsvorrichtung gemäß Fig. 3 in nicht kontaktiertem Zustand in einer Draufsicht auf die Bestückungsseite der Leiterplatte und
- Fig. 6: den Eckbereich der Kontaktierungsvorrichtung wie in Fig. 5 in einer Draufsicht auf die Rückseite der Leiterplatte.

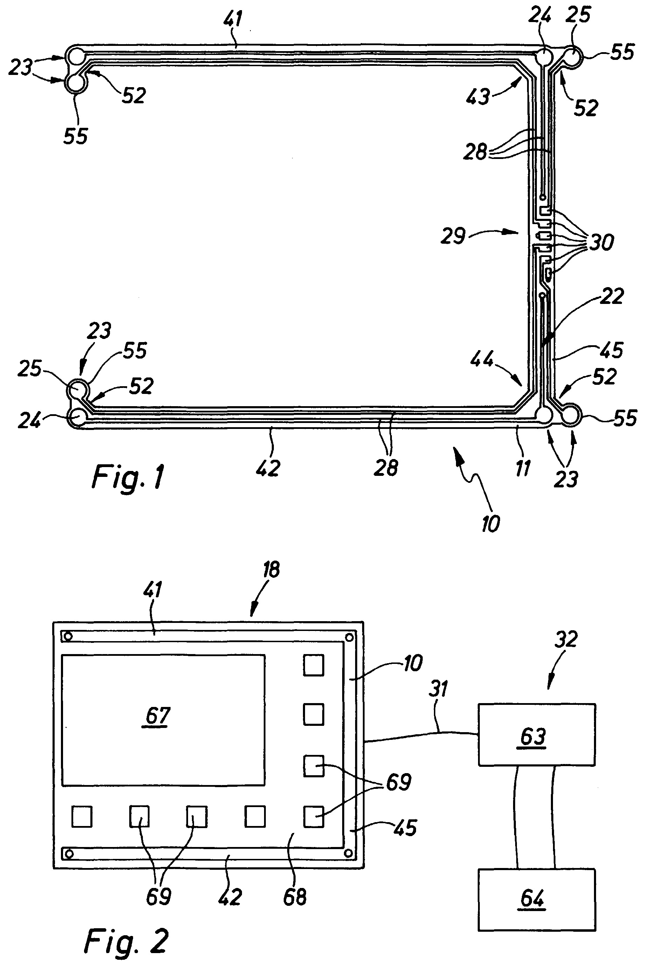

Aus Fig. 1 geht eine erste Ausführungsform der erfindungsgemäßen Kontaktierungsvorrichtung 10 hervor, die über eine flexible Leiterplatte 11 verfügt, die beispielsgemäß eine U-artige Form aufweist. Die Kontaktierungsvorrichtung 10 dient zum Kontaktieren wenigstens eines elektrischen Bauteils 12 bzw. Drucksensors 19 von verschiedenen Kontaktseiten 13, 14 her.

Beim bevorzugten Ausführungsbeispiel stellt die Kontaktierungsvorrichtung den Bestandteil eines druckempfindlichen Bildschirms 18 (touch panel) dar, wie dies in Fig. 2 schematisch angedeutet ist. Zu diesem Zweck ist die Kontaktierungsvorrichtung 10 zum Kontaktieren von mehreren Drucksensoren 19 ausgeführt, die die elektrischen Bauteile 12 darstellen.

Die Leiterplatte 11 verfügt über eine Bestückungsseite 22, auf der vier Gruppen 23 von jeweils zwei beabstandeten elektrisch leitfähigen Kontaktflächen 24, 25 vorgesehen sind. Jede Gruppe 23 von Kontaktflächen 24, 25 ist zur Kontaktierung eines Drucksensors 19 vorgesehen. Es versteht sich, daß sowohl die Anzahl der Gruppen 23 als auch die Anzahl der Kontaktflächen 24, 25 pro Gruppe in Abhängigkeit von der Anwendung der Kontaktierungsvorrichtung 10 und dem zu kontaktierenden Drucksensor 19 variieren kann.

Auf der Bestückungsseite 22 der Leiterplatte 11 verlaufen mehrere Signalleiterbahnen 28, die die elektrische Verbindung von den Kontaktflächen 24, 25 zu einem Anschlußbereich 29 darstellen, in dem auf der Bestückungsseite 22 Anschlußflächen 30 vorgesehen sind, mit denen beispielsweise eine elektrische Leiteranordnung 31 oder eine Steckeranordnung verbindbar ist. Auf diese Weise können die Anschlußflächen 24, 25 mit externen elektrischen bzw. elektronischen Baueinheiten 32 beispielsweise zur Signalübertragung elektrisch verbunden werden.

In diesem Anschlußbereich 29 können kurze Abschnitte einer oder mehrerer der Leiterbahnen 28 auf der der Bestückungsseite 22 entgegengesetzten Rückseite 33 der Leiterplatte 11 verlaufen. Diese Abschnitte sind jedoch sehr kurz verglichen mit den auf der Bestückungsseite 22 verlaufenden Leiterbahnabschnitten. Die Signalleiterbahnen 28 sind daher überwiegend auf der Bestückungsseite 22 der Leiterplatte 11 vorgesehen.

Im Unterschied zu dem dargestellten bevorzugten Ausführungsbeispiel der Kontaktierungsvorrichtung 10 besteht die Möglichkeit, zusätzlich nach herkömmlicher Art und Weise kontaktierte Bauteile bzw. Baugruppen an der Leiterplatte 11 vorzusehen. Beispielsweise könnten solche Bauelemente zur Signalverarbeitung der auf den Leiterbahnen 28 geführten elektrischen Signale dienen.

Auf der Rückseite 33 der Leiterplatte 11 ist eine Abschirmung 37 vorhanden, die eine oder mehrere elektrisch leitfähige Flächen 38 aufweist, die insbesondere in Gebrauchslage der Kontaktierungsvorrichtung 10 mit Masse verbunden sind. Beim Ausführungsbeispiel bildet eine zusammenhängende elektrisch leitfähige Fläche 38 die Abschirmung 37.

Die Abschirmung 37 ist derart angeordnet, daß sie die auf der Bestückungsseite 22 vorhandenen Signalleiterbahnen und Kontaktflächen 24, 25 von der Rückseite 33 der Leiterplatte 11 her überdeckt. Sie ist den Signalleiterbahnen 28 bzw. Kontaktflächen 24, 25 auf der entgegengesetzten Seite 33 der Leiterplatte 11 gegenüberliegend vorgesehen und ragt zumindest überwiegend in Erstreckungsrichtung der Leiterplatte 11 über die abzuschirmenden Leiterbahnen 28 bzw. Kontaktflächen 24, 25 hinaus. Es ist auch möglich, die Rückseite 33 der Leiterplatte 11 annähernd vollständig mit der Abschirmung 37 zu überdecken.

Wie dies aus Fig. 1 hervorgeht, ist die Leiterplatte 11 rahmenähnlich ausgeführt, was durch ihren Verwendungszweck als Bestandteil eines druckempfindlichen Bildschirms 18 bedingt ist, worauf später noch näher eingegangen wird. Sie ist jedoch nicht vollständig geschlossen ausgebildet, sondern weist eine zu einer Seite hin offene U-förmige Gestalt auf. An den beiden freien Enden der parallel zueinander verlaufenden Schenkel 41, 42 der Leiterplatte 11 ist jeweils eine der Gruppen 23 von Kontaktflächen 24, 25 vorgesehen. Die beiden anderen Kontaktflächen-Gruppen 23 befinden sich in jeweils einem Übergangsbereich 43, 44 eines Schenkels 41, 42 zu einem diese beiden Schenkel 41, 42 verbindenden Querstück 45 der Leiterplatte 11. Das Querstück 45 verläuft im wesentlichen rechtwinkelig zur Erstreckungsrichtung der beiden Schenkel 41, 42 und verbindet diese in dem den freien Enden der Schenkel 41, 42 entgegengesetzten Endbereich.

Zum Kontaktieren der Drucksensoren 19 werden die jeweils zugeordneten Kontaktflächen 24, 25 einer gemeinsamen Gruppe 23 mit Kontaktgegenflächen 48, 49 des Drucksensors 19 elektrisch verbunden. Die Kontaktgegenflächen 48, 49 befinden sich auf entgegengesetzten Kontaktseiten 13, 14 des Drucksensors 19. Es versteht sich, daß bei anderen zu kontaktierenden elektrischen Bauteilen sowohl die Anzahl als auch die Anordnung der Kontaktgegenflächen 48, 49 variieren kann. Dementsprechend ist die Anordnung der Kontaktflächen 24, 25 einer gemeinsamen Gruppe 23 an die Erfordernisse anzupassen. Beispielsweise müssen hierbei der Abstand, die Kontur oder die Größe der Kontaktflächen 24, 25 entsprechend den Anforderungen verändert werden.

Die Kontaktgegenflächen 48, 49 des Drucksensors 19 haben eine kreisrunde Form, so daß die Kontaktflächen 24, 25 der Kontaktierungsvorrichtung 10 ebenfalls kreisförmig gewählt wurden, wobei deren Durchmesser größer bemessen werden kann als der Durchmesser der zugeordneten Kontaktgegenflächen 48, 49.

Zwischen jeweils zwei Kontaktflächen 24, 25 einer gemeinsamen Gruppe 23 verläuft ein Biegebereich 52, indem die flexible Leiterplatte 11 umlegbar bzw. umklappbar ist, so daß die Kontaktflächen 24, 25 mit den Kontaktgegenflächen 48, 49 des jeweils zugeordneten Drucksensors 19 zu dessen Kontaktierung elektrisch in Kontakt gelangen. Beispielsgemäß ist die Leiterplatte 11 in einem jeweiligen Biegebereich 52 bei hergestellter Kontaktierung derart umgeklappt, daß die beiderseits des Biegebereichs 52 befindlichen Kontaktflächen 24, 25 aufeinander zu weisen und von entgegengesetzten Kontaktseiten 13, 14 her mit dem betreffenden Drucksensor 19 elektrisch verbunden sind.

Eine der beiden Kontaktflächen 25 aus einer jeweiligen Gruppe 23 ist an einer umlegbaren, laschenähnlichen Partie 55 der Leiterplatte 11 angeordnet. Der Biegebereich 52 befindet sich ebenfalls an der laschenähnlichen Partie 55 zwischen den beiden Kontaktflächen 24, 25.

Zum Herstellen des elektrischen Kontaktes mit dem jeweiligen Drucksensor 19 wird die laschenähnliche Partie 55 derart umgeklappt, daß sich die beiden Kontaktflächen 24, 25 einander zugewandt gegenüberliegen, wobei der Drucksensor 19 sandwichartig dazwischenliegt. Durch dieses Umlegen der laschenähnlichen Partie 55 wird der Kontaktbereich zwischen Drucksensor 19 und Leiterplatte 11 automatisch beidseitig abgeschirmt, da die Rückseite der Leiterplatte 11 nach außen gewandt ist und die dort vorgesehene Abschirmung 37 diesen Kontaktbereich zu beiden Seiten abdeckt.

Zur mechanischen und elektrischen Verbindung der von den Drucksensoren 19 gebildeten Bauteile 12 und der Leiterplatte 11 sind Klebeschichten vorgesehen. Diese sind beispielsgemäß von jeweils einer beidseitig mit Leitkleber beschichteten Leitfolie 58 gebildet, die bei hergestellter Kontaktierung jeweils zwischen einer Kontaktfläche 24, 25 und der zugeordneten Kontaktgegenfläche 48, 49 angeordnet ist. Als Leitfolie 58 kann beispielsweise Kupferfolie verwendet werden. Die Größe und Kontur der Leitfolie 58 sind an die Abmessungen der Kontaktfläche 24, 25 bzw. Kontaktgegenfläche 48, 49 angepaßt.

Es versteht sich, daß alternativ zu der Klebeverbindung auch jede beliebige andere Verbindungsmethode einsetzbar ist, beispielsweise Löten.

In Fig. 2 ist die Kontaktierungsvorrichtung in ihrer Verwendung als Bestandteil des druckempfindlichen Bildschirms 18 schematisch dargestellt. Die vier mit der Leiterplatte 11 verbundenen Drucksensoren bilden ein Rechteck und sind in den Eckbereichen des Bildschirms 18 angeordnet. Die Kontaktierungsvorrichtung 10 wird hierbei von einem nicht näher gezeigten leitfähigen Rahmen des Bildschirms 18 abgedeckt, der der Bestückungsseite 22 der Leiterplatte 11 gegenüberliegend angeordnet und insbesondere ebenfalls an Masse angeschlossen ist. Hierdurch wird die Kontaktierungsvorrichtung 10 außerhalb der bereits durch die Abschirmung 37 abgeschirmten Kontaktierungsbereiche von der Bestückungsseite 22 her ebenfalls vollständig abgeschirmt. Alternativ zu dem leitfähigen Rahmen des Bildschirms 18 könnte die Leiterplatte 11 auf ihrer Bestückungsseite 22 zunächst isoliert und dann mit einem leitfähigen Lack zur Abschirmung versehen werden.

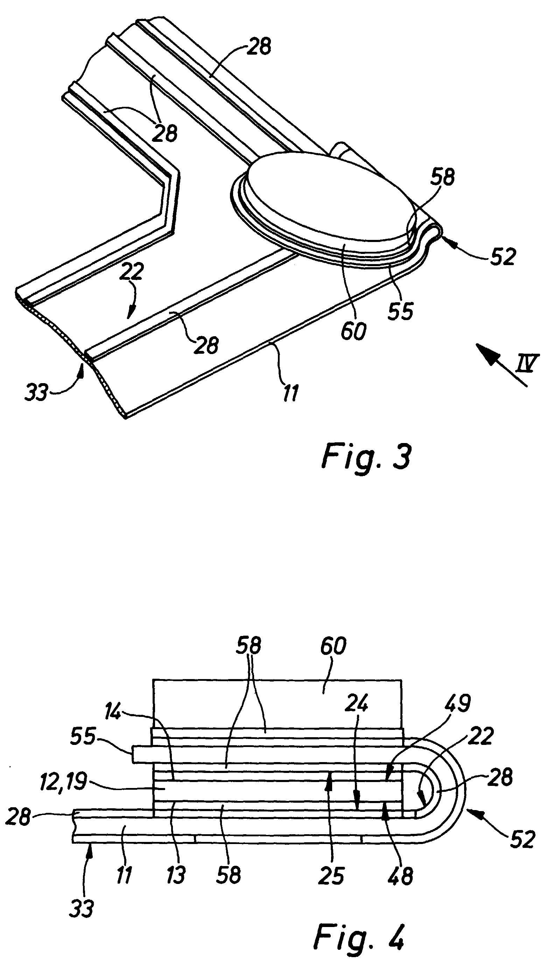

Beispielsgemäß liegt der leitfähige Rahmen auf Zwischenstücken 60 auf, die in Gebrauchslage zwischen Rahmen und Leiterplatte 11 angeordnet sind. Aus den Fig. 3 und 4 geht hervor, daß jedem an der Leiterplatte 11 vorgesehenen Drucksensor 19 ein Zwischenstück 60 zugeordnet ist, das bei hergestellter Kontaktierung zwischen dem Rahmen des Bildschirms 18 und dem jeweiligen Drucksensor 19 sitzt. Die Zwischenstücke 60 sind beispielsgemäß elektrisch leitfähig und mit Hilfe jeweils einer selbstklebenden Leitfolie 58 auf den Abschnitt der Abschirmung 37 aufgeklebt, der auf der Rückseite der laschenähnlichen Partie 55 vorgesehen ist. Somit ist über die leitfähigen Zwischenstücke 60 und die Leitfolie 58 eine elektrische Verbindung zwischen der Abschirmung 37 und dem leitfähigen Rahmen des Bildschirms 18 hergestellt.

Mit dem leitfähigen Rahmen ist eine nicht näher gezeigte transparente Bildschirmscheibe verbunden, durch die der Bediener des Bildschirms hindurchsehen und zum Hervorrufen gewünschter Funktionen aufdrücken kann. Je nachdem, wo die Druckstelle an der Bildschirmscheibe erfolgt, findet eine unterschiedlich starke Belastung der Drucksensoren 19 statt, die entsprechend der Druckbelastung elektrische Signale auf den Signalleiterbahnen 28 hervorruft. Diese Signale werden über die elektrische Leiteranordnung 31 einer Auswerteeinheit 32 zugeführt, die beispielsweise von einem Controller 63 und einer damit verbundenen Rechnereinheit 64, insbesondere Personal Computer, gebildet sein kann. Die Auswerteeinheit 32 ermittelt die Position der Druckstelle auf der Bildschirmscheibe aus den Sensorsignalen und ruft gegebenenfalls die zugeordnete gewünschte Funktion hervor, wie dies bei druckempfindlichen Bildschirmen üblich ist.

Innerhalb des vom Bediener durch die Bildschirmscheibe einsehbaren Bereichs kann der druckempfindliche Bildschirm 18 zum Beispiel über ein Anzeigefeld 67 zum Anzeigen variabler Bilder und Informationen und über ein Bedienfeld 68 verfügen, das eine oder mehrere Funktionstasten 69 aufweist. Durch einen Druck zum Beispiel mit dem Finger auf die Bildschirmscheibe an der einer Funktionstaste 69 entsprechenden Stelle kann der Bediener die dieser Funktionstaste 69 zugeordnete Funktion hervorrufen. Ein solcher druckempfindlicher Bildschirm 18 (touch panel) kann beispielsweise als Bedieneinrichtung für Bankautomaten od.dgl. verwendet werden.

## Patentansprüche

1. Kontaktierungsvorrichtung für vier von verschiedenen Kontaktseiten (13, 14) her elektrisch zu kontaktierende Drucksensoren (19) als Bestandteil eines druckempfindlichen Bildschirms (18), wobei Kontaktflächen (24, 25) zueinander beabstandet an einer Bestückungsseite (22) einer flexiblen Leiterplatte (11) vorgesehen sind, die zum Herstellen des elektrischen Kontaktes mit elektrisch leitfähigen Kontaktgegenflächen (48, 49) an den Kontaktseiten (13, 14) der Drucksensoren (19) an mindestens einem jeweils zwischen zwei den Drucksensoren (19) zugeordneten Kontaktflächen (24, 25) verlaufenden Biegebereich (52) umlegbar ist, so daß die Kontaktflächen (24, 25) der Leiterplatte (11) mit den Kontaktgegenflächen (48, 49) der Drucksensoren (19) in Kontakt gelangen, wobei die Leiterplatte (11) eine rahmenähnliche oder U-artige Gestalt aufweist und so ausgebildet ist, daß die Drucksensoren (19) im kontaktierten Zustand die Ecken eines Rechteckes bilden.

2. Kontaktierungsvorrichtung nach Anspruch 1, dadurch gekennzeichnet, daß sich im kontaktierten Zustand wenigstens zwei der Kontaktflächen (24, 25) durch den Drucksensor (19) voneinander beabstandet gegenüberliegen.

3. Kontaktierungsvorrichtung nach Anspruch 1 oder 2, dadurch gekennzeichnet, daß zumindest eine der den Drucksensoren (19) zugeordneten Kontaktflächen (24, 25) an einer umlegbaren, laschenähnlichen Partie (55) der Leiterplatte (11) vorgesehen ist, wobei der Biegebereich (52) jeweils an der laschenähnlichen Partie (55) verläuft.

4. Kontaktierungsvorrichtung nach einem der Ansprüche 1 bis 3, dadurch gekennzeichnet, daß überwiegend auf der Bestückungsseite (22) Signalleiterbahnen (28) vorhanden sind, die zumindest teilweise mit den Kontaktflächen (24, 25) verbunden sind.

5. Kontaktierungsvorrichtung nach einem der Ansprüche 1 bis 4, dadurch gekennzeichnet, daß auf der der Bestückungsseite (22) entgegengesetzten Rückseite (33) der Leiterplatte (11) eine elektrisch leitfähige Flächen (38) aufweisende Abschirmung (37) vorgesehen ist, die insbesondere die auf der Bestückungsseite (22) vorhandenen Signalleiterbahnen (28) und Kontaktflächen (24, 25) überdeckt.

6. Kontaktierungsvorrichtung nach Anspruch 5, dadurch gekennzeichnet, daß die Bestückungsseite (22) mittels eines leitfähigen Lacks oder eines leitfähigen Rahmens abgedeckt ist.

7. Kontaktierungsvorrichtung nach einem der Ansprüche 1 bis 6, dadurch gekennzeichnet, daß zur elektrischen und mechanischen Verbindung der Kontaktflächen (24, 25) der Leiterplatte (11) mit den jeweils zugeordneten Kontaktgegenflächen (48, 49) der Drucksensoren (19) Klebeschichten vorgesehen sind.

8. Kontaktierungsvorrichtung nach Anspruch 7, dadurch gekennzeichnet, daß die Klebeschicht von einer beidseitig mit Leitkleber versehenen Leitfolie (58) gebildet wird, die bei hergestellter Verbindung jeweils zwischen Kontaktfläche (24, 25) und zugeordneter Kontaktgegenfläche (48, 49) angeordnet ist.
